(19) Europäisches Patentamt / European Patent Office / Office européen des brevets

(11) **EP 2 259 096 A1**

(12) **EUROPEAN PATENT APPLICATION**

(43) Date of publication:
08.12.2010 Bulletin 2010/49

(51) Int Cl.:
*G02B 1/04* (2006.01)   *G02B 13/00* (2006.01)
*H01L 27/146* (2006.01)   *H04N 5/225* (2006.01)

(21) Application number: 10160047.6

(22) Date of filing: 15.04.2010

(84) Designated Contracting States:
AT BE BG CH CY CZ DE DK EE ES FI FR GB GR
HR HU IE IS IT LI LT LU LV MC MK MT NL NO PL
PT RO SE SI SK SM TR
Designated Extension States:
AL BA ME RS

(30) Priority: 03.06.2009 KR 20090049100

(71) Applicant: SAMSUNG ELECTRONICS CO., LTD.
Suwon-si
Gyeonggi-do 442-742 (KR)

(72) Inventors:
• Choi, Min-seog
Seoul (KR)
• Lee, Eun-sung
Gyeonggi-do (KR)
• Jung, Kyu-dong
Gyeonggi-do (KR)

(74) Representative: Greene, Simon Kenneth
Elkington and Fife LLP
Prospect House
8 Pembroke Road
Sevenoaks
Kent TN13 1XR (GB)

(54) **Wafer-level lens module and image pickup module including the same**

(57) Provided are a wafer-level lens module and an image pickup module including the same. The wafer lens module includes a plurality wafer-scale lenses. At least one of the plurality of wafer-scale lenses, such as a wafer-scale lens positioned toward an object side, includes a substrate and a glass lens element formed on one side of the substrate. The glass lens element may be a one-sided lens or a double-sided lens. When the glass lens is a double-sided lens, the substrate may have a through hole. The remaining wafer-scale lenses each include a substrate and polymer lens elements made of UV curable polymer and formed on both sides of the substrate. Also, spacers are interposed between the wafer-scale lenses, along the edge portions of the substrates, so as to maintain predetermined intervals between the wafer-scale lenses.

FIG.2

EP 2 259 096 A1

**Description**

**BACKGROUND**

**1. Field**

Exemplary embodiments relate to an image pickup module, and more particularly, to an image pickup module and a lens module included in the same.

**2. Description of the Related Art**

Following the development of digital technologies, digital convergence is becoming increasingly popular. Applications of digital convergence are most active in the field of media and communications. A representative product incorporating digital convergence is a so-called "camera phone", where an image pickup module such as a digital camera or a digital camcorder is combined with a mobile phone. Image pickup modules such as digital cameras and the like are installed in other mobile electronic devices including laptop computers and Personal Digital Assistants (PDAs), in addition to mobile phones.

As mobile electronic devices with image pickup modules that are small and slimline become more popular, demand for small, light-weight and low-cost image pickup modules is increasing accordingly. Additionally, in order to keep pace with the recent trend in which various electronic devices, such as a MP3 player, a Portable Multimedia Player (PMP), a Digital Multimedia Broadcasting (DMB) television, etc., in addition to an image pickup module, are integrated into a camera phone, the demand for small, low-cost image pickup modules is further increasing.

In order to meet these demands, a wafer-level image pickup module has been developed. A conventional lens module (hereinafter, referred to as a wafer-level lens module) for a wafer-level image pickup module has a stacked structure of transparent substrates and polymer lenses. The wafer-level lens module is manufactured by arranging and stacking a plurality of transparent wafers each having polymer lenses formed in an array using a replica method and then cutting them. Accordingly, the wafer-level lens module can be manufactured to be small and light-weight at low cost, which allows mass production.

The conventional wafer-level lens, which is manufactured by the replica method, is made of mainly UV curable polymer. In manufacturing a wafer-level lens using UV curable polymer, the manufacturing process is simplified, which leads to reduction of manufacturing costs. However, there are difficulties in applying such a wafer-level lens module that uses polymer lenses to 5 Mega pixels or higher resolution cameras. The reason is that polymer lenses are easily distorted with respect to shape and show high chromatic aberration.

When camera phones were first introduced, the demand on performance of the camera installed therein was not so high. However, recently, as types of mobile phones have become more varied to satisfy the various demands or tastes of consumers, the demand on increased resolution of a camera module installed in a camera phone has increased. However, with appearance of camera phones with 5 Mega pixels or higher resolution cameras, there are difficulties in supporting such a high-resolution camera phone using a wafer-level lens module constructed using only polymer lenses.

**SUMMARY**

Aspects of exemplary embodiments may provide a wafer-level lens module which is small and light-weight, suitable for installation in small electronic devices, and which can support high-resolution image capture of 3 Mega pixels or higher, and an image pickup module including the wafer-level lens module.

Another aspect of an exemplary embodiment relates to a wafer-level lens module which can support high-resolution image capture by minimizing chromatic aberration produced when light passes through a plurality of lenses, and an image pickup module including the wafer-level lens module.

Another aspect of an exemplary embodiment relates to a wafer-level lens module which can support high-resolution display by allowing selection of a refraction index over a broad range while minimizing chromatic aberration, and an image pickup module including the wafer-level lens module.

Another aspect of an exemplary embodiment relates to a wafer-level lens module which can support high-resolution display by appropriately stacking and combining a plurality of wafer-scale lenses having different shapes into a single lens module, and an image pickup module including the wafer-level lens module.

In one general aspect, there is provided a wafer-level lens module including a first wafer-scale lens and a second wafer-scale lens spaced a predetermined distance from the first wafer-scale lens. The first wafer-scale lens includes a first substrate and a glass lens element formed thereon, and the second wafer-scale lens includes a second substrate and a first polymer lens element formed thereon.

In another general aspect, there is provided a wafer-level lens module in which a plurality of wafer-scale lenses are stacked on an image sensor, wherein the plurality of wafer-scale lenses include at least one glass lens plane and at least one polymer lens plane.

In another general aspect, there is provided a wafer-level lens module including first, second and third wafer-scale lenses and spacers. The first wafer-scale lens includes a first lens group which is composed of a first substrate, a glass lens element formed on one side of the first substrate, and a polymer lens element formed on the other side of the first substrate. The second wafer-scale lens includes a second lens group which is composed of a second substrate and a pair of polymer lens elements formed on both sides of the second substrate, and the third wafer-scale lens includes a third lens group which is composed of a third substrate and a pair of polymer lens elements formed respectively on both sides of the third substrate. The spacers are formed between the first and second wafer-scale lenses and between the second and third wafer-scale lenses.

In another general aspect, there is provided an image pickup module including the above-described wafer-level lens module and an image sensor which is spaced a predetermined length of a spacer from the wafer-level lens module and senses images created through the wafer-level lens module.

Other objects, features, and advantages will be apparent from the following description, the drawings, and the claims.

## BRIEF DESCRIPTION OF THE DRAWINGS

FIG. 1 is a perspective view illustrating an exemplary image pickup module.

FIG. 2 is a cross-sectional view of the exemplary image pickup module of FIG. 1 cut along a line X-X'.

FIG. 3 is a cross-sectional view of a modification of the exemplary image pickup module of FIG. 1 cut along the line X-X'.

FIG. 4A is an exemplary graph numerically showing a relationship of Modulation Transfer Function (MTF) with respect to spatial frequency in an exemplary wafer-level lens module.

FIG. 4B are exemplary graphs numerically showing aberrations of an exemplary wafer-level lens module.

Elements, features, and structures are denoted by the same reference numerals throughout the drawings and the detailed description, and the size, scale, and proportions of some elements may be exaggerated or skewed in the drawings for clarity and convenience.

## DETAILED DESCRIPTION

The detailed description is provided to assist the reader in gaining a comprehensive understanding of the exemplary methods, apparatuses, and/or systems described herein. Various changes, modifications, and equivalents of the exemplary systems, apparatuses, and/or methods described herein will likely suggest themselves to those of ordinary skill in the art. Also, descriptions of well-known functions and constructions may be omitted to increase clarity and conciseness.

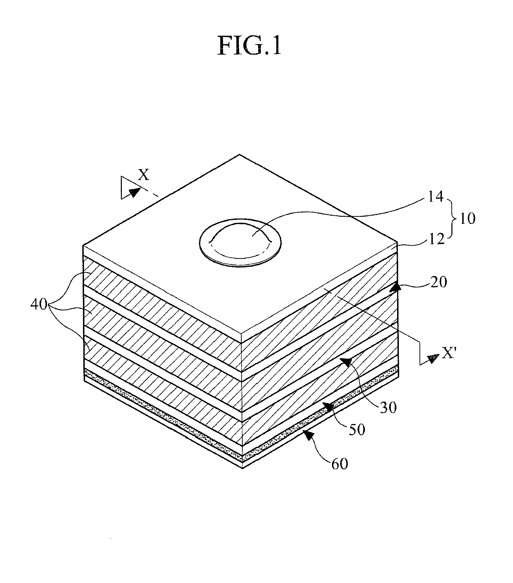

FIG. 1 is a perspective view illustrating an exemplary image pickup module. The image pickup module may include a wafer-level lens module composed of a plurality of wafer-scale lenses, and an image sensor. In FIG. 1, elements constructing the image pickup module may be exaggerated in size, shape, scale, thickness, etc. for clarity. Also, the number of the wafer-scale lenses included in the image pickup module is not limited to three as shown in FIG. 1.

Referring to FIG. 1, the wafer-level lens module includes three wafer-scale lenses 10, 20, and 30, and three spacers 40 for spacing the wafer-scale lenses 10, 20, and 30 a predetermined distance from each other. The wafer-level lens module may be a rectangular parallelepiped. In this case, each of the wafer-scale lenses 10, 20, and 30 forming the wafer-level lens module may have a cuboidal form, unlike the shape of a general lens. The wafer-scale lenses 10, 20, and 30 having a quadrangle plane are spaced a predetermined distance from each other by the spacers 40 that are formed along the respective edge portions. Varying the heights of the spacers 40 may change the distances between the wafer-scale lenses 10, 20, and 30. The image pickup module further includes an image sensor 60 which forms an image by receiving incident light passing through the wafer-scale lenses 10, 20, and 30. Details about the image sensor 60 will be given later.

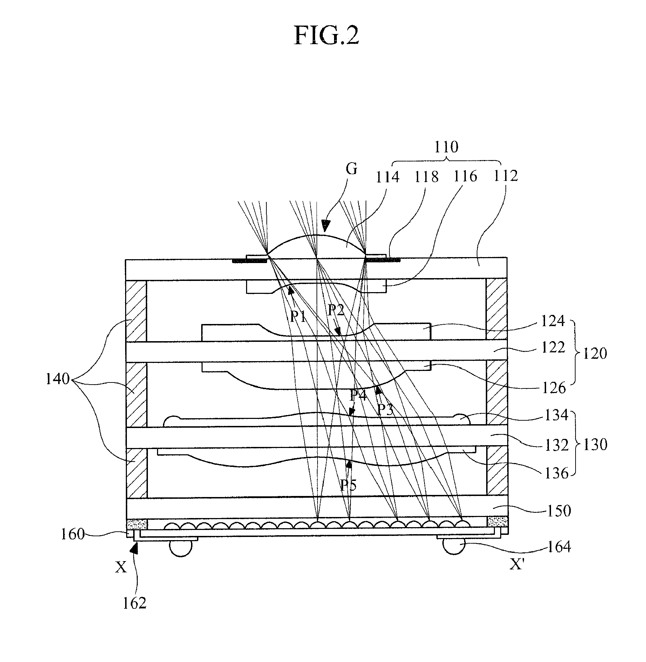

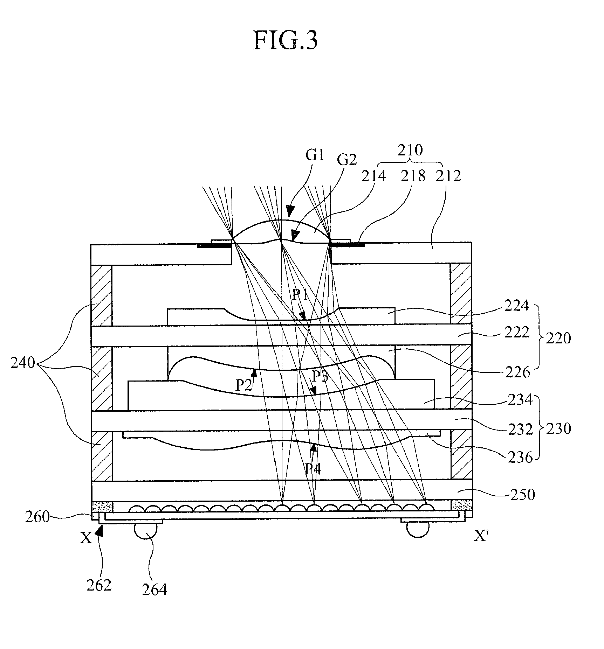

In the exemplary wafer-level lens module, the wafer-scale lens 10 provides at least one glass lens plane and the wafer-scale lenses 20 and 30 provide at least one polymer lens plane. Details about the configuration of the wafer-level lens module will be described later with reference to FIGS. 2 and 3. In the wafer-level lens module according to the current exemplary embodiment, unlike a conventional wafer-level lens module in which all lens elements are made of UV-curable polymer, some lens elements are glass lenses. The glass lens 10 may be a separate product manufactured by molding, etc. The glass lens 10 may be arranged and attached at a predetermined position on a substrate using transparent adhesive (not shown) or arranged and fixed using grooves engraved on the substrate.

As such, a lens element of the exemplary wafer-level lens module may be a molded glass lens. The molded glass lens may have a low chromatic aberration and may allow selection of a refraction index over a broad range. Accordingly, such a glass lens may improve, when adopted in a wafer-level lens module, the resolution and definition of an associated image pickup module.

The rectangular parallelepiped shape of the wafer-level lens module relates to a method of manufacturing the image pickup module according to the current exemplary embodiment. In more detail, in an exemplary method of manufacturing the image pickup module according to the current exemplary embodiment, arrays of wafer-scale lenses 10, 20 and 30 are formed on a transparent substrate and then spaced a predetermined distance from each other by putting spacers 40 therebetween, to thus be stacked with spacers 40 therebetween. The spacers 40 may be formed at the edge portions of the respective wafer-scale lenses. Also, the array of the wafer-scale lens 30 may be positioned close to an image sensor (60) side (for example, a glass cover) and may be spaced a predetermined distance from the image sensor 60 by the spacers 40. Then, by dicing the stacked arrays of wafer-scale lenses 10, 20, and 30 along the spacers 40, an image pickup module including the image sensor 60 and the wafer-scale lenses 10, 20 and 30 may be manufactured. Through this exemplary manufacturing method, a small, thin wafer-level image pickup module may be manufactured at low cost.

FIG. 2 is a cross-sectional view of the exemplary image pickup module of FIG. 1 cut along a line X-X'.

Referring to FIG. 2, the exemplary image pickup module may include a plurality of wafer-scale lenses 110, 120, and 130, a plurality of spacers 140 and an image sensor 160.

The image sensor 160 may include a photosensitive element array which forms an image by receiving light passing through the wafer-scale lenses 110, 120, and 130. The image sensor 160 may be a Complementary Metal-Oxide Semiconductor (CMOS) image sensor or a Charge Coupled Device (CCD), however, is not limited to these. To the exemplary image pickup module illustrated in FIG. 2 may be applied a wafer-scale package, in which a glass cover 150 is disposed over the image sensor 160 by bonding with the image sensor 160, and a solder ball 164 below the glass cover 150 electrically connects to the image sensor 160 by a through via 162 passing through the glass cover 150. Above or below the glass cover 150, an optical coating layer, such as an optical low-pass filter, a color difference filter, an IR filter, a UV filter, or other filter may be provided.

The wafer-scale lenses 110, 120, and 130 are spaced from each other by spacers 140. The spacers 140 are used to maintain the intervals between the wafer-scale lenses 110, 120, and 130 and between the wafer-scale lens 130 and the image sensor 160 (in detail, between the wafer-scale lens 130 and the glass cover 150 bonded above the image sensor 160). The size and thickness of each spacer 140 may depend on the shapes or thicknesses of individual lens elements 114, 116, 124, 126, 134, and 136. In the current exemplary embodiment, the sizes of the spacers 140 are not limited. The spacers 140 may be formed along the edge portions of the wafer-scale lenses 110, 120, and 130, having a rectangular parallelepiped, and the glass cover 150. Additionally, the intervals between the wafer-scale lenses 110, 120, and 130, and between the wafer-scale lens 130 and the image sensor 160 lenses may be the same or may be different for each spacer.

The three wafer-scale lenses 110, 120, and 130 include transparent substrates 112, 122 and 132, and lens elements (114 and 116), (124, 126) and (134, 136) formed respectively on one or both surfaces of the transparent substrates 112, 122 and 132, respectively. Also, according to the current exemplary embodiment, at least one of the lens elements 114, 116, 124, 126, 134, and 136 is a glass lens element made of a glass material, and the remaining lens elements are polymer lens elements made of UV curable polymer. In the exemplary embodiment shown in FIG. 2, the lens element 114 formed on the upper surface of the first wafer-scale lens 110, that is, on the object-side surface of the first wafer-scale lens 110 is a glass lens element, and the remaining lens elements 116, 124, 126, 134, and 136 are polymer lens elements.

Since the polymer lens elements 116, 124, 126, 134, and 136 may be manufactured by a conventional method, a detailed description thereof will be omitted. Meanwhile, the glass lens element 114 may be manufactured as a separate product, and then positioned and attached at a determined location on the upper surface of the transparent substrate 112 using transparent adhesive. There are difficulties in installing such a glass lens element in a wafer-level lens module, but utilizing a tray substrate capable of arranging a glass lens element 114 in an array after turning it over this facilitates the attaching of a glass lens element on a transparent substrate using transparent adhesive. In the current exemplary embodiment, the glass lens element 114 is a one-sided lens whose one side is a lens plane and whose other side is a flat plane. The flat plane side of the glass lens element 114 may be attached on the flat transparent substrate 112 using transparent adhesive (not shown). Hereinafter, the first through third wafer-scale lenses 110, 120, and 130 will be described in more detail.

The first wafer-scale lens 110 includes a first transparent substrate 112, a first lens group (114, 116) and an aperture stop 118. The first transparent substrate 112 may be made of the same substance as the glass lens element 114 or the polymer lens element 116, or may be made of a substance with different optical characteristics. The first lens group (114, 116) may be composed of the glass lens element 114 formed on one surface (for example, the object-side surface) of the first transparent substrate 112, and the polymer lens element 116 formed on the other surface (for example, the image sensor-side surface) of the first transparent substrate 112.

The aperture stop 118 is to limit a received amount of light. The aperture stop 118 may be disposed on the object-side surface of the first transparent substrate 118, however it may be located at any other location. The aperture stop 118 may be formed with an opaque metal film such as a Cr film or made of an opaque material such as photoresist. For example, the aperture stop 118 may be formed by coating a Cr film on the upper surface (the object-side surface) of the first transparent substrate 112.

The second wafer-scale lens 120 includes a second transparent substrate 122 and a second lens group (124, 126). The second transparent substrate 122 is also made of a transparent material, and may be made of the same material as the second lens group (124, 126) or may be made of a material with different optical characteristics. The second lens group (124, 126) may be composed of polymer lens elements 124 and 126 that are respectively formed on both sides (the object-side and image sensor-side surfaces) of the second transparent substrate 122. The second wafer-scale lens 120 is spaced a predetermined distance from the first wafer-scale lens 110 by spacers 140 formed at the edge portions of the second transparent substrate 122.

The third wafer-scale lens 130 includes a third transparent substrate 132 and a third lens group (134, 136). Likewise, the third transparent substrate 132 is made of a transparent material, and may be made of the same material as the third lens group (134, 136) or may be made of a material with different optical characteristics. The third lens group (134, 136) may be composed of polymer lens elements 134 and 136 that are respectively formed on both sides (the object-side and image sensor-side surfaces) of the third transparent substrate 132. The third wafer-scale lens 130 is spaced a predetermined distance from the second wafer-scale lens 120 by spacers 140 formed at the edge portions of the third transparent substrate 132, and is also spaced a predetermined distance from the image sensor 160 by spacers 140 formed at the edge portions of the glass cover 150.

FIG. 3 is a cross-sectional view of a modification of the exemplary image pickup module of FIG. 1 cut along the line X-X'. Referring to FIG. 3, the exemplary image pickup module may include a plurality of wafer-scale lenses 210, 220, and 230, a plurality of spacers 240 and an image sensor 250. The exemplary image pickup module may additionally include a solder ball 264 below a glass cover 250 electrically connects to an image sensor 260 by a through via 262 passing through the glass cover 250. The exemplary image pickup module illustrated in FIG. 3 differs from the exemplary image pickup module illustrated in FIG. 2, in at least that the glass lens element 214 is a double-sided lens, and the glass lens element 114 is a single sided lens. Accordingly, the exemplary image pickup module of FIG. 3 will be described based on the difference from the structure of FIG. 2, below, and details may be omitted in the following description will be understood from the above-description with respect to FIG. 2.

An image sensor 260 includes a photoresistive element array which forms images by receiving light passing through wafer-scale lenses 210, 220, and 230 and a glass cover 250, and for example, the image sensor 260 may be a CMOS image sensor or a CCD, or other image sensor. Above or below the glass cover 250 may be coated an optical low-pass filter, a color difference filter, an IR filter, a UV filter, or other filter. A wafer-level lens module is composed of the three wafer-scale lenses 210, 220, and 230 and the spacers 240. The spacers 240 are used to maintain the intervals between the wafer-scale lenses 210, 220, and 230 and between the wafer-scale lens 230 and the image sensor 260.

A first substrate 212 of the wafer scale lens 210 may be made of a transparent or opaque material (for example, silicon). If the first substrate 212 is a transparent substrate, an aperture stop 218 may be needed, but if the first substrate 212 is an opaque substrate, no aperture stop may be required. Second and third substrates 222 and 232 may be transparent substrates made of a transparent material. The wafer scale lenses 210, 220, and 230 include lens elements 214, 224, 226, 234, and 236 formed respectively on one side or both sides of the substrates 212, 222 and 232. At least one of the lens elements 214, 224, 226, 234, and 236 may be a glass lens element made of a glass material, and the remaining lens elements may be polymer lens elements made of UV curable polymer. In the example illustrated in FIG. 3, the lens element 214 formed on the upper surface of the first wafer-scale lens 210, that is, on the object-side surface of the first wafer-scale lens 210 is a glass lens element, and the remaining lens elements 224, 226, 234, and 236 are polymer lens elements.

The glass lens element 214 may be manufactured as a single product, and then positioned and attached at a determined location on the upper surface of the first substrate 212 using transparent adhesive. In the current exemplary embodiment, both sides of the glass lens element 214 are used as lens planes, and for this, a through hole may be formed in the first substrate 212, as shown in FIG. 3. The diameter of the through hole may be longer than the mean effective diameter of the glass lens element 214 and shorter than the total diameter of the glass lens element 214. The edge portion of the glass lens element 214, that is, the portion which corresponds to between the whole area and mean effective area of the glass lens element 214, may be attached on the first substrate 212 using transparent adhesive so that the glass lens element 214 can cover the entire through hole. If the first substrate 212 is made of an opaque material, the through hole may be formed with a diameter that is identical to the aperture of the aperture stop 218. Now, the first, second and third wafer-scale lenses 210, 220, and 230 will be described in more detail.

The first wafer-scale lens 210 includes the first substrate 212, the first lens group 214 and the aperture stop 218. As described above, the first substrate 212 may be made of a transparent or opaque material (for example, silicon) and has the through hole with a predetermined diameter. The through hole allows the glass lens element 214 to act as a double-sided lens. The first lens group 214 may be a glass lens element which is formed on one side (for example, the object-side surface) of the first substrate 212 and configured to cover the through hole. When the first substrate 212 is a transparent substrate, the aperture stop 218 may be formed on the object-side surface of the first transparent substrate 212. The aperture stop 218 may be formed with an opaque Cr film or photoresist.

The second wafer-scale lens 220 includes a second transparent substrate 222 and a second lens group (224, 226). The second lens group (224, 226) may be composed of polymer lens elements formed on both sides (for example, the object-side and image sensor-side surfaces) of the second transparent substrate 222. The third wafer-scale lens 230 includes a third transparent substrate 232 and a third lens group (234, 236), and the third lens group (234, 236) may be composed of polymer lens elements formed on both sides (for example, the object-side and image sensor-side surfaces) of the third transparent substrate 232. The intervals between the second wafer-scale lens 220, the third wafer-scale lens 230, and the image sensor 260 are maintained by the spacers 240.

According to an exemplary embodiment, the shapes of the respective lens elements constructing the wafer-level lens module described above with reference to FIGS. 2 and 3 may be designed in consideration of a combination of predetermined optical power levels in order to provide for the use with a high resolution imaging sensor. For example, the first lens group including a glass lens element may have plus optical power and the second and third lens groups composed of only polymer lens elements may have minus optical power. An exemplary combination of optical power levels shown in Table 1 may provide higher resolution. The refraction indices, dispersion indices and shapes of the individual lens groups are shown in Table 1.

[Table 1]

|  | Refraction Index | Dispersion Index | Optical Power | Shape |
|---|---|---|---|---|
| First Lens Group | 1.47-1.6 | 55-85 | + | Meniscus (Object-side Surface+, Sensor-side Surface-) |
| Second Lens Group | 1.55-1.7 | 20-40 | - | Meniscus (Object-side Surface-, Sensor-side Surface+) |
| Third Lens Group | 1.5-1.6 | 30-50 | - | Inflected |

The lens elements constructing the lens groups are all aspheric, and the height of each lens element may be calculated by Equation 1 below.

$$z(r) = \frac{c^2 r^2}{1 + \sqrt{\left(1 - (1+k)c^2 r^2\right)}} + \sum_{i=2} a_{2i} r^{2i},$$

$$(1)$$

where $r$ is a radical position at a lens center, $z(r)$ is the height of the lens, c is a radius of curvature (ROC) at the lens center, k is a conic constant, and $a_{2i}$ is aspheric coefficients. The aspheric coefficients are shown as A, B, C, D, E and F starting from i=2, in Tables 2 and 3.

<Numerical Example 1>

Table 2 shows geometry parameters that digitize the surface geometries of individual lens elements constructing the exemplary wafer-level lens module illustrated in FIG. 2. This numerical example 1 relates to a wafer-level lens module whose height (a distance from the object-side surface of the first lens group to the image sensor) is 5.15 mm and in which a maximum of the mean effective diameters is 4 mm.

[Table 2]

| Lens Parameter | G1 | P1 | P2 | P3 | P4 | P5 |
|---|---|---|---|---|---|---|
| ROC | 1.33493786 | 2.56031424 | -4.16164342 | -10.51832820 | 4.47512917 | 3.04818332 |
| K | 0.12097672 | 8.71769794 | -6.05072580 | -16.32855529 | 3.86365551 | -0.26075888 |
| A | 0.00663897 | 0.00703757 | -0.10074999 | -0.17725283 | -0.25156487 | -0.08113082 |
| B | -0.00320127 | 0.00489293 | 0.22753680 | 0.17545267 | 0.14600108 | 0.00742382 |
| C | 0.05014370 | 0.04576030 | -0.98623718 | -0.10670460 | -0.04577235 | 0.00773096 |
| D | -0.11310837 | -0.10190063 | 2.13756928 | 0.04809991 | 0.01081313 | -0.00436679 |
| E | 0.14017582 | 0.07627931 | -2.37376019 | -0.00970944 | -0.00164668 | 0.00093661 |
| F | -0.05867845 | -0.00002114 | 1.05701398 | -0.00001137 | 0.00002541 | -0.00007403 |
| Center Thickness | 0.37921375 | 0.11156407 | 0.15741668 | 0.43654437 | 0.24299977 | 0.42812446 |
| Aperture | 1.544557203 | 1.395780324 | 1.659433264 | 2.64924539 | 3.035332583 | 4.004069285 |

<Numerical Example 2>

Table 3 shows geometry parameters that digitize the surface geometries of individual lens elements constructing an exemplary wafer-level lens module illustrated in FIG. 3. This numerical example 2 relates to a wafer-level lens module whose height (a distance from the object-side surface of the first lens group to the image sensor) is 5.0 mm and in which a maximum of the mean effective diameters is 3.8 mm.

[Table 3]

| Lens Parameter | G1(concave) | G2(concave) | P1(concave) | P2(convex) | P3(concave) | P4(convex) |
|---|---|---|---|---|---|---|
| ROC | 1.23372402 | 13.14625617 | -2.12337367 | -2.56789760 | -2.50904669 | 6.64661603 |
| K | -0.87539364 | 9.99763207 | -9.99901725 | -10.00000000 | -7.90742492 | 3.50650990 |
| A | 0.07664546 | 0.03313417 | -0.17650633 | -0.03373472 | -0.11522722 | -0.06448560 |
| B | 0.05142433 | -0.01663050 | 0.23552736 | 0.12856952 | 0.04729733 | 0.02067419 |
| C | -0.02010857 | 0.29676735 | -1.18747329 | -0.12604816 | 0.06413616 | -0.00341649 |
| D | 0.27401076 | -0.99347956 | 3.59265312 | 0.10867632 | -0.16559955 | 0.00180515 |
| E | -0.50367554 | 1.73682181 | -5.25382488 | -0.02000000 | 0.13660349 | -0.00023863 |
| F | 0.44116603 | -1.10917165 | 3.66764679 | 0.00050000 | -0.03501724 | 0.00002095 |
| Center Thickness | 0.50000000 | | 0.25164743 | 0.39979700 | 0.28605604 | 0.50000000 |
| Aperture | 1.51918979 | 1.22318727 | 1.31434930 | 2.00155774 | 2.40395386 | 3.77051082 |

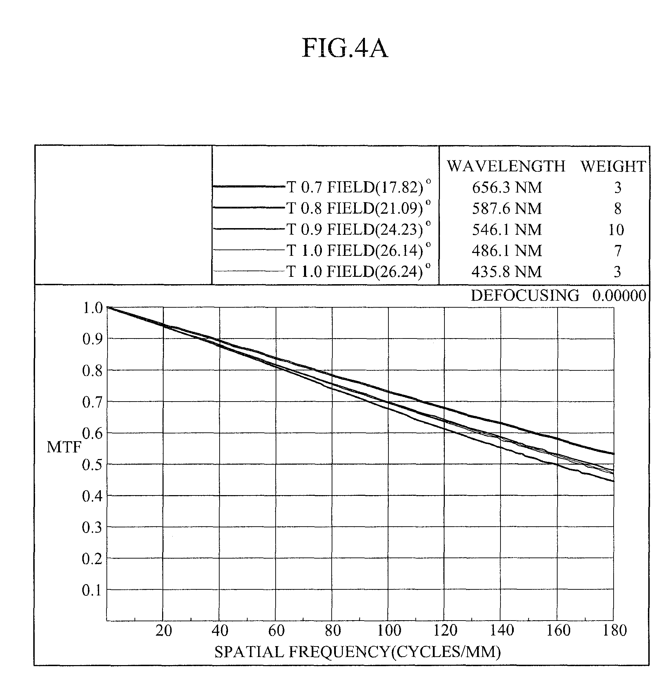

FIG. 4A is a graph numerically showing a relationship of Modulation Transfer Function (MTF) with respect to spatial frequency in an exemplary wafer-level lens module having lenses with the geometry parameters shown in Table 2 or 3, wherein a pixel size of 1.4$\mu$m is applied and a sensor in a 1/4-inch format is utilized. It is seen in FIG. 4A that the exemplary wafer-level lens module has high resolution, as a MTF value at a spatial frequency of about 180 lp/mm is greater than 0.4.

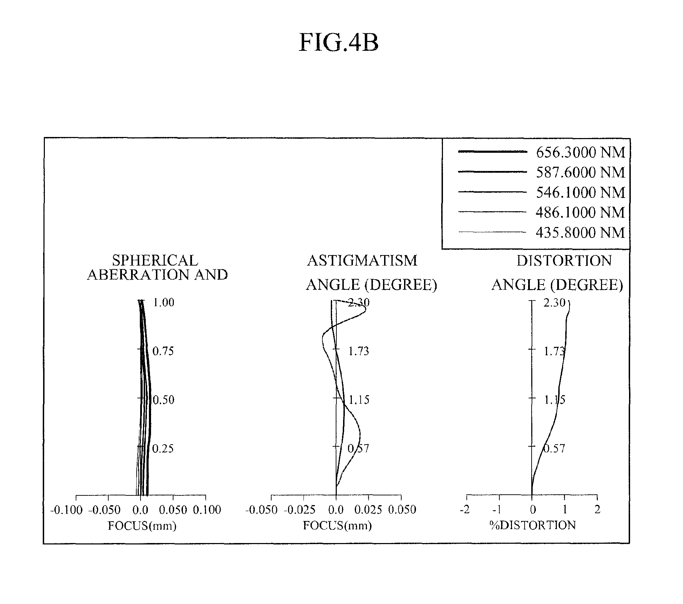

FIG. 4B show graphs numerically showing aberrations of an exemplary wafer-level lens module having lenses with the geometry parameters shown in Table 2 and 3. It is seen in FIG. 4B that the exemplary wafer-level module has a performance applicable to 5 Mega pixel phone cameras, as spherical aberration and astigmatism are less than +/- 0.015 and distortion is less than 1%.

As described above, existing wafer-level lens modules are manufactured by polymer replication using a mold, and accordingly, all lenses are manufactured with polymer, particularly, with UV curable polymer. Since polymer causes high chromatic aberration at a high refraction index, color deterioration is inevitable when polymer is applied to 3 Mega pixel or higher resolution camera phones. However, a wafer-level lens module according exemplary embodiments may be successfully applied to high resolution camera phones and other devices, since it can support 3 Mega pixel or higher resolution image sensors.

In the wafer-level lens module according to the current exemplary embodiment, the first wafer-scale lens disposed toward the object side may use a lens group having plus optical power, and the second and third wafer-scale lenses disposed close to the image sensor may use a lens group having minus optical power. By utilizing this combination of lenses, a wafer-level lens module supporting higher resolution may be provided.

A number of exemplary embodiments have been described above. Nevertheless, it will be understood that various modifications may be made. For example, suitable results may be achieved if the described techniques are performed in a different order and/or if components in a described system, architecture, device, or circuit are combined in a different manner and/or replaced or supplemented by other components or their equivalents. Accordingly, other implementations are within the scope of the following claims. Additionally, expressions such as "at least one of", when preceding a list of elements, modify the entire list of elements and do not modify each element of the list.

## Claims

1. A wafer-level lens module comprising:

   a first wafer-scale lens comprising a first substrate and a glass lens comprising a glass material and formed on a first side of the first substrate; and
   a second wafer-scale lens spaced a predetermined distance from the first wafer-scale lens, the second wafer-scale lens comprising a second substrate and a first polymer lens comprising a polymer material and formed on a first side of the second substrate.

2. The wafer-level lens module of claim 1, wherein the glass lens is bonded to the first substrate.

3. The wafer-level lens module of claim 1 or 2, wherein the glass lens is a one-sided lens, one surface of which is flat.

4. The wafer-level lens module of any preceding claim, wherein the first substrate is made of an opaque material, and has a through hole whose diameter is longer than a mean effective diameter of the glass lens and shorter than a total diameter of the glass lens, and
   the glass lens is a double-sided lens whose edge portion is bonded to the first substrate, while covering the through hole.

5. The wafer-level lens module of any preceding claim, wherein the first wafer-scale lens further comprises a second polymer lens comprising a polymer material and formed on a second side of the first substrate, and the second wafer-scale lens further comprises a third polymer lens made of a polymer material and formed on a second side of the second substrate.

6. The wafer-level lens module of any preceding claim, wherein between the first substrate and the second substrate, at least one spacer is interposed to space the first wafer-scale lens a predetermined distance from the second wafer-scale lens.

7. The wafer-level lens module of any preceding claim, further comprising a third wafer-scale lens spaced a predetermined distance from the second wafer-scale lens, the third wafer-scale lens comprising a third substrate and a fourth polymer lens comprising a polymer material and formed on a first side of the third substrate.

8. The wafer-level lens module of claim 7, wherein the third wafer-scale lens further comprises a fifth polymer lens comprising a polymer material and formed on a second side of the third substrate.

9. The wafer-level lens module of claim 7 or 8, wherein a lens group of the first wafer-scale lens has plus optical power, and each of a lens group of the second wafer-scale lens and a lens group of the third wafer-scale lens have minus optical power.

10. The wafer-level lens module of claim 9, wherein the lens group of the first wafer-scale lens has a meniscus shape which is convex toward an object side, the lens group of the second wafer-scale lens has a meniscus shape which is convex toward a sensor side, and the lens group of the third wafer-scale lens has a curved shape having points of inflection.

11. The wafer-level lens module of any preceding claim, wherein the first, second, and third wafer-scale lenses each have a quadrangle shape having the same size, and the spacers are formed on edge portions of the quadrangle shape.

12. The wafer-level lens module of any preceding claim, further comprising an aperture stop disposed on the first surface of the first substrateand
optionally wherein the first substrate is made of an opaque material, and has a through hole whose diameter is the same as an aperture of the aperture stop.

13. The wafer-level lens module of any preceding claim, wherein the glass lens of the first wafer-scale lens is aspheric.

14. The wafer-level lens module of any preceding claim, wherein the mean effective diameters of the first and the second wafer-scale lenses are a maximum of 4 mm.

15. An image pickup module comprising:

a wafer level lens module according to claim 7 or any claim depending on claim 7;
an image sensor to sense images formed via the third wafer-scale lens; and
wherein at least one of the plurality of spacers is formed between the third wafer-scale lens and the image sensor, the plurality of spacers being formed along edge portions of the first wafer-scale lens, the second wafer-scale lens, and the third wafer-scale lens.

# FIG.1

# FIG.2

# FIG.3

# FIG.4A

| | WAVELENGTH | WEIGHT |
|---|---|---|
| —— T 0.7 FIELD(17.82)° | 656.3 NM | 3 |
| —— T 0.8 FIELD(21.09)° | 587.6 NM | 8 |
| —— T 0.9 FIELD(24.23)° | 546.1 NM | 10 |
| —— T 1.0 FIELD(26.14)° | 486.1 NM | 7 |
| —— T 1.0 FIELD(26.24)° | 435.8 NM | 3 |
| | DEFOCUSING | 0.00000 |

MTF vs SPATIAL FREQUENCY(CYCLES/MM)

FIG.4B

| | Europäisches Patentamt |
|---|---|
| | European Patent Office |
| | Office européen des brevets |

## EUROPEAN SEARCH REPORT

**Application Number**

EP 10 16 0047

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2008/011003 A2 (TESSERA NORTH AMERICA [US]; FELDMAN MICHAEL R [US]; MORRIS JAMES E [US]) 24 January 2008 (2008-01-24) | 1-3,5-15 | INV. G02B1/04 G02B13/00 H01L27/146 H04N5/225 |
| Y | * paragraphs [0116] - [0129]; figures 10,11 * | 4 | |
| Y | US 2008/121784 A1 (CHANG CHAO-CHI [CN] ET AL) 29 May 2008 (2008-05-29) * paragraphs [0028] - [0031]; figure 2 * | 4 | |
| A | US 2008/123199 A1 (HONG JUNG HA [KR]) 29 May 2008 (2008-05-29) * paragraphs [0014] - [0037] * | 1-15 | |
| A | EP 1 443 754 A2 (SANYO ELECTRIC CO [JP]) 4 August 2004 (2004-08-04) * paragraphs [0017] - [0045] * | 1-15 | |
| A | WO 2008/133946 A1 (FLEXTRONICS AP LLC [US]; SINGH HARPUNEET [US]) 6 November 2008 (2008-11-06) * pages 4-9 * | 1-15 | |
| | | | **TECHNICAL FIELDS SEARCHED (IPC)** |
| | | | G02B H01L H04N |

The present search report has been drawn up for all claims

| Place of search | Date of completion of the search | Examiner |
|---|---|---|
| Munich | 20 July 2010 | Stemmer, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 10 16 0047

This annex lists the patent family members relating to the patent documents cited in the above-mentioned European search report.
The members are as contained in the European Patent Office EDP file on
The European Patent Office is in no way liable for these particulars which are merely given for the purpose of information.

20-07-2010

| Patent document cited in search report | | Publication date | Patent family member(s) | | Publication date |
|---|---|---|---|---|---|
| WO 2008011003 A2 | | 24-01-2008 | NONE | | |
| US 2008121784 A1 | | 29-05-2008 | NONE | | |
| US 2008123199 A1 | | 29-05-2008 | JP 2008129606 A<br>KR 20080047002 A | | 05-06-2008<br>28-05-2008 |
| EP 1443754 A2 | | 04-08-2004 | CN 1517736 A<br>JP 2004226872 A<br>KR 20040068865 A<br>US 2004212719 A1 | | 04-08-2004<br>12-08-2004<br>02-08-2004<br>28-10-2004 |
| WO 2008133946 A1 | | 06-11-2008 | CA 2685083 A1<br>CN 101681085 A<br>US 2009015706 A1 | | 06-11-2008<br>24-03-2010<br>15-01-2009 |

EPO FORM P0459

For more details about this annex : see Official Journal of the European Patent Office, No. 12/82